# EUROPEAN PATENT APPLICATION

(11) **EP 4 668 268 A1**
(43) Date of publication of application: **24.12.2025**
(21) Application number: 24883581.1
(22) Date of filing: 20.09.2024

(54) **MEMORY AND STORAGE DEVICE**

(30) Priority: 30.04.2024 CN 202410546174
(71) Applicant: CXMT Corporation, Hefei City, Anhui Province 230601 (CN)
(72) Inventor: CHEN, Qinchen, Hefei, Anhui 230601 (CN); WANG, Zijian, Hefei, Anhui 230601 (CN)
(74) Representative: Gulde & Partner
(86) International application number: PCT/CN2024/120048
(87) International publication number: WO 2025/227598

(57) **Abstract**

A memory and a memory device. The memory includes: a plurality of storage cells arranged in an array, configured such that when a storage cell is selected, data stored in the storage cell is read out from a bit line to a first data bus; and a set circuit, connected to the first data bus to receive a set signal, and configured to enable the first data bus based on the set signal and output a first data bit when the memory is in a first mode, or disable the first data bus based on the set signal and output a preset data bit when the memory is in a second mode, where the first mode is a normal read mode, and the second mode is a duty cycle training assist mode. In this way, the first data bus can be selectively enabled or disabled in different operation modes of the memory to output corresponding data. Therefore, the first data bus is shared, and an area of the memory is saved.

## Description

This application claims priority to Chinese Patent Application No. 202410546174.1, filed with the China National Intellectual Property Administration on April 30, 2024 and entitled "MEMORY AND MEMORY DEVICE", which is incorporated herein by reference in its entirety.

### TECHNICAL FIELD

Embodiments of the present disclosure relate to the field of semiconductor technologies, and in particular, to a memory and a memory device.

### BACKGROUND

In the semiconductor industry, a clock signal of a memory chip such as a dynamic random access memory (Dynamic Random Access Memory, DRAM) is generally provided by an external control chip. The clock signal may have a duty cycle deviation during generation, transmission, and internal processing in the DRAM.

To correct the duty cycle deviation of the clock signal, a duty cycle adjustment circuit is proposed in the related art, and the duty cycle deviation of the clock signal can be corrected by using the duty cycle adjustment circuit.

### SUMMARY

Embodiments of the present disclosure provide a memory and a memory device.

According to some embodiments of the present disclosure, a first aspect of the embodiments of the present disclosure provides a memory, including: a plurality of storage cells arranged in an array, configured such that when a storage cell is selected, data stored in the storage cell is read out from a bit line to a first data bus; and a set circuit, connected to the first data bus to receive a set signal, and configured to enable the first data bus based on the set signal and output a first data bit when the memory is in a first mode, or disable the first data bus based on the set signal and output a preset data bit when the memory is in a second mode, where the first mode is a normal read mode, and the second mode is a duty cycle training assist mode.

In some embodiments, the set circuit includes a setter, the set signal includes a first set signal and a second set signal, an input end of the setter is connected to the first data bus, a first set end receives the first set signal, and a second set end receives the second set signal, where in the first mode, levels of the first set signal and the second set signal are different, or in the second mode, levels of the first set signal and the second set signal are the same.

In some embodiments, the memory further includes a decoding circuit, configured to receive a register code of a mode register and perform decoding to generate the set signal.

In some embodiments, the memory further includes a latch circuit, connected to the decoding circuit to receive a mode register write signal, and configured such that when the mode register write signal is valid, the latch circuit is controlled to output the set signal, or that when the mode register write signal is invalid, the latch circuit is controlled to latch the set signal.

In some embodiments, the memory further includes N parallel-to-serial conversion circuits, each of which is correspondingly connected to M set circuits and configured to receive data bits output by the M set circuits and sample the data bits based on a first clock signal, and perform logic processing to generate second data, each piece of the second data including M serial data bits, where N and M are even integers.

In some embodiments, a clock cycle of the first clock signal is M times a clock cycle of a system clock signal, and in each of the parallel-to-serial conversion circuits, valid pulse periods of first clock signals received by the M set circuits do not overlap each other.

In some embodiments, when the memory is in the second mode, levels of the M serial data bits in each piece of the second data are the same, and N is equal to the number of bits in a preset data pattern.

In some embodiments, the parallel-to-serial conversion circuit further receives a first write signal, and is configured such that when the first write signal is valid, the parallel-to-serial conversion circuit triggers the generation of the second data.

In some embodiments, the memory further includes N selection circuits, each of which is connected to two of the parallel-to-serial conversion circuits to receive the corresponding second data and is configured as follows: when the memory is in the first mode, the second data output by N/2 of the selection circuits in an odd mode is the same as the second data output by other N/2 of the selection circuits in an even mode; and when the memory is in the second mode, the second data output by the N/2 of the selection circuits in the odd mode is different from the second data output by the other N/2 of the selection circuits in the even mode, where two parallel-to-serial conversion circuits connected to each of the N/2 selection circuits are the same as two parallel-to-serial conversion circuits connected to a corresponding one of the other N/2 selection circuits.

In some embodiments, the selection circuits are configured as follows: when the memory is in the first mode, the second data output by first N/2 of the selection circuits in the odd mode is the same as the second data output by last N/2 of the selection circuits in the even mode; and when the memory is in the second mode, the second data output by the first N/2 of the selection circuits in the odd mode is different from the second data output by the last N/2 of the selection circuits in the even mode, where two parallel-to-serial conversion circuits connected to each of the first N/2 selection circuits are the same as two parallel-to-serial conversion circuits connected to a corresponding one of the last N/2 selection circuits.

In some embodiments, the N selection circuits further receive second clock signals, perform sampling, and output two pieces of third data, each piece of the third data including N/2 pieces of parallel second data, where in the odd mode, the second clock signals received by the N/2 of the selection circuits are advanced by half a clock cycle compared with the second clock signals received by the other N/2 of the selection circuits; and in the even mode, the second clock signals received by the N/2 of the selection circuits are delayed by half a clock cycle compared with the second clock signals received by the other N/2 of the selection circuits.

In some embodiments, the second clock signals include a second clock odd signal and a second clock even signal, clock cycles of the second clock odd signal and the second clock even signal are the same, and only one of the second clock odd signal and the second clock even signal is valid at a same moment; the odd mode corresponds to the second clock odd signal being valid, and the even mode corresponds to the second clock even signal being valid; in the odd mode, the N/2 of the selection circuits perform sampling based on the second clock odd signal, and the other N/2 of the selection circuits perform sampling based on a second clock odd delayed signal; and in the even mode, the N/2 of the selection circuits perform sampling based on a second clock even delayed signal, and the other N/2 of the selection circuits perform sampling based on the second clock even signal, where the second clock odd delayed signal is delayed by half a clock cycle compared with the second clock odd signal, and the second clock even delayed signal is delayed by half a clock cycle compared with the second clock even signal.

In some embodiments, each of the selection circuits includes an odd selection circuit and an even selection circuit, the odd selection circuit includes an odd sampling circuit connected to one of the parallel-to-serial conversion circuits to receive a first piece of the second data, the even selection circuit includes a selector and an even sampling circuit connected to two of the parallel-to-serial conversion circuits, one end of the selector receives the first piece of the second data, another end of the selector receives a second piece of the second data, a control end of the selector receives a first selection signal, and the selection circuits are configured as follows: in the odd mode, the odd selection circuit receives the first piece of the second data and performs sampling based on the second clock odd signal; and in the even mode, when the first selection signal is at a first level, the selector outputs the first piece of the second data, or when the first selection signal is at a second level, the selector outputs the second piece of the second data, and the even sampling circuit performs sampling based on the second clock even delayed signal; or in the odd mode, the odd selection circuit receives the first piece of the second data and performs sampling based on the second clock odd delayed signal; and in the even mode, when the first selection signal is at a first level, the selector outputs the first piece of the second data, or when the first selection signal is at a second level, the selector outputs the second piece of the second data, and the even sampling circuit performs sampling based on the second clock even signal.

In some embodiments, the memory further includes an output module, connected to the N selection circuits and configured to receive the third data and output fourth data to an input/output interface, where the fourth data includes N*M serial data bits.

According to some embodiments of the present disclosure, a second aspect of the embodiments of the present disclosure further provides a memory device, including the memory according to any one of the first aspect; and a controller, where the controller is coupled to the memory and configured to enable the memory device to: send a command to the memory through the controller, where the command includes a normal read command or a duty cycle training assist mode command, and the memory reads out data based on the received command; and if the command is the duty cycle training assist mode command, compare the data received by the memory device through the controller with preset data to determine and adjust a duty cycle of a system clock signal.

Embodiments of the present disclosure provide a memory and a memory device. The memory includes: a plurality of storage cells arranged in an array, configured such that when a storage cell is selected, data stored in the storage cell is read out from a bit line to a first data bus; and a set circuit, connected to the first data bus to receive a set signal, and configured to enable the first data bus based on the set signal and output a first data bit when the memory is in a first mode, or disable the first data bus based on the set signal and output a preset data bit when the memory is in a second mode, where the first mode is a normal read mode, and the second mode is a duty cycle training assist mode. In this way, the set circuit is disposed on the first data bus, and the first data bus can be selectively enabled or disabled in different operation modes of the memory to output corresponding data. Therefore, the first data bus is shared, and an area of the memory is saved. In addition, after the memory switches from the normal read mode to the duty cycle training assist mode, the first data bus is disabled, and data in the normal read mode is no longer switched, thereby greatly reducing power consumption.

### BRIEF DESCRIPTION OF DRAWINGS

One or more embodiments are exemplarily illustrated in figures in the accompanying drawings corresponding to the one or more embodiments. These exemplary illustrations are not intended to limit the embodiments. Elements with the same reference numerals in the accompanying drawings are similar elements, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.
FIG. 1 is a schematic diagram of a composition structure of a memory according to an embodiment of the present disclosure;
FIG. 2 is a schematic diagram of a composition structure of a set circuit according to an embodiment of the present disclosure;
FIG. 3 is a schematic diagram of another composition structure of a memory according to an embodiment of the present disclosure;
FIG. 4 is a schematic diagram of a composition structure of a decoding circuit according to an embodiment of the present disclosure;
FIG. 5 is a schematic diagram of another composition structure of a memory according to an embodiment of the present disclosure;
FIG. 6 is a schematic diagram of a composition structure of a latch circuit according to an embodiment of the present disclosure;
FIG. 7 is a schematic diagram of another composition structure of a memory according to an embodiment of the present disclosure;
FIG. 8 is a schematic diagram of a composition structure of a parallel-to-serial conversion circuit according to an embodiment of the present disclosure;
FIG. 9 is a schematic timing diagram corresponding to a parallel-to-serial conversion circuit according to an embodiment of the present disclosure;
FIG. 10 is a schematic diagram of a composition structure of a first write signal generation circuit according to an embodiment of the present disclosure;
FIG. 11 is a schematic diagram of another composition structure of a memory according to an embodiment of the present disclosure;
FIG. 12 is a schematic diagram of another composition structure of a memory according to an embodiment of the present disclosure;
FIG. 13 is a schematic diagram of a composition structure of a selection circuit according to an embodiment of the present disclosure;
FIG. 14 is a first schematic timing diagram corresponding to a selection circuit according to an embodiment of the present disclosure;
FIG. 15 is a second schematic timing diagram corresponding to a selection circuit according to an embodiment of the present disclosure; and
FIG. 16 is a schematic diagram of a composition structure of a memory device according to an embodiment of the present disclosure.

### DESCRIPTION OF EMBODIMENTS

To make the objectives, technical solutions, and advantages of the embodiments of the present disclosure clearer, the following clearly and thoroughly describes the technical solutions in the embodiments of the present disclosure with reference to the accompanying drawings in the embodiments of the present disclosure. It is clear that the described embodiments are some but not all of the embodiments of the present disclosure. All other embodiments obtained by a person of ordinary skill in the art based on the embodiments of the present disclosure without creative efforts shall fall within the protection scope of the present disclosure. In addition, although content disclosed in the present disclosure is described by using one or several exemplary instances, it should be understood that each aspect of the disclosed content can also independently constitute a complete implementation.

It should be noted that the brief description of terms in the present disclosure is solely for ease of understanding the embodiments described below, and is not intended to limit the embodiments of the present disclosure. Unless otherwise specified, these terms should be understood according to their ordinary and usual meanings.

In the specification, claims, and accompanying drawings of the present disclosure, the terms "first", "second", and the like are intended to distinguish between similar or homogeneous objects or entities, but do not necessarily imply a limitation on a specific order or sequence, unless otherwise stated. It should be understood that the terms used in this way are interchangeable under appropriate circumstances, for example, allowing implementations in an order other than that illustrated or described in the embodiments of the present disclosure.

In addition, the terms "include", "have", and any other variant thereof are intended to cover a non-exclusive inclusion. For example, a product or device that includes a series of components is not necessarily limited to those expressly listed components, but may include other components that are not expressly listed or are inherent to the product or device.

The term "module" used in the present disclosure refers to any known or later developed hardware, software, firmware, artificial intelligence, fuzzy logic, or a combination of hardware and/or software code that is capable of performing functions related to the element.

Generally, a memory device includes a controller and a memory. In some embodiments of the present disclosure, the memory may be a dynamic random access memory (DRAM), such as a low power double data rate (LPDDR) DRAM. The controller and the memory communicate through several buses. For example, the memory receives commands and addresses through a command/address bus, and provides data between the controller and the memory through a data bus.

In addition, various clock signals can be provided between the controller and the memory through a clock bus. When a clock signal periodically transitions between a low clock level and a high clock level, the clock signal is active. Conversely, when the clock signal remains at a constant clock level and does not periodically transition, the clock signal is inactive.

The clock bus may include signal lines. The signal lines are used to provide system clock signals CK_t and CK_c received by the memory, data clocks WCK_t and WCK_c received by the memory, and access data clock signals RDQS_t and RDQS_c provided by the memory to the controller.

For a write command, when the memory is ready to receive written data from the controller, the controller provides WCK_t and WCK_c clock signals to the memory. The WCK_t and WCK_c clock signals may be used by the memory to generate an internal clock signal for timing an operation of receiving the written data by a circuit. The data is provided by the controller, and the memory receives the written data based on the WCK_t and WCK_c clock signals. The written data is written to the memory corresponding to a memory address.

For a read command, when the memory is ready to provide read data to the controller, the controller provides WCK_t and WCK_c clock signals to the memory. The WCK_t and WCK_c clock signals may be used by the memory to generate access data clock signals RDQS_t and RDQS_c. The memory performing the read operation provides the RDQS_t and RDQS_c clock signals to the controller, for timing the provision of the read data to the controller. The controller can use the RDQS_t and RDQS_c clock signals to receive the read data.

The clock signal has a duty cycle. Within a period of a binary periodic signal, the duty cycle is a fraction of time during which the signal is valid. For example, the clock signal may alternately transition between a logic high level (for example, a high voltage level) and a logic low level (for example, a low voltage level). The memory device may adjust the duty cycle of the clock signal to ensure that the clock signal matches a desired duty cycle (for example, 50%).

A clock signal of a DRAM is generally provided by an external controller. The clock signal may have a duty cycle deviation during generation, transmission, and internal processing in the DRAM. To correct the duty cycle deviation of the clock signal in the DRAM, a duty cycle adjuster (Duty Cycle Adjuster, DCA for short) circuit is proposed in the prior art. The controller may use a DCA mode register to adjust duty cycles of data DQ and data clock DQS signals in the DRAM to compensate for an alignment problem between the DQ and DQS signals in the DRAM. Generally, the adjustment of the clock signal has impact on a DQ output, so that correct data is output.

An internal clock of the DRAM may be divided into a two-phase clock and a four-phase clock. For example, the four-phase clock may be divided into a first-phase clock ICLK (0°), a second-phase clock QCLK (90°), a third-phase clock IBCLK (180°), and a fourth-phase clock QBCLK (270°). A DCA circuit with a four-phase clock generally adjusts remaining three clock signals by using the ICLK as a reference.

The controller needs to distinguish between the ICLK and the IBCLK, and then can control the memory to adjust the duty cycle. Therefore, a DRAM industry standard proposes: a DCA training assist mode I (DCA training assist mode I), which targets the two-phase clock, and helps the controller to determine whether a first burst length (burst length, BL) is aligned with the ICLK or the IBCLK, that is, determine which clock samples the first bit of the output data; and a DCA training assist mode II (DCA training assist mode II), which targets the four-phase clock, where the DRAM internally generates a data pattern (data pattern) and returns data to the controller, and the controller compares the data with a preset data pattern to determine whether the data pattern output by the DRAM starts from the first bit or a third bit. If it starts from the first bit, the first bit of the output data is sampled by the ICLK. If it starts from the third bit, the first bit of the output data is sampled by the IBCLK. Then the controller can distinguish between the ICLK and the IBCLK and then can align the four-phase clock well.

Embodiments of the present disclosure provide a memory, including: a plurality of storage cells arranged in an array, configured such that when a storage cell is selected, data stored in the storage cell is read out from a bit line to a first data bus; and a set circuit, connected to the first data bus to receive a set signal, and configured to enable the first data bus based on the set signal and output a first data bit when the memory is in a first mode, or disable the first data bus based on the set signal and output a preset data bit when the memory is in a second mode, where the first mode is a normal read mode, and the second mode is a duty cycle training assist mode. In this way, the set circuit is disposed on the first data bus, and the first data bus can be selectively enabled or disabled in different operation modes of the memory to output corresponding data. Therefore, the first data bus is shared, and an area of the memory is saved. In addition, after the memory switches from the normal read mode to the duty cycle training assist mode, the first data bus is disabled, and data in the normal read mode is no longer switched, thereby greatly reducing power consumption.

The embodiments of the present disclosure are described in detail below with reference to the accompanying drawings. However, it may be understood by a person of ordinary skill in the art that in the embodiments of the present disclosure, many technical details are provided to enable readers to better understand the present disclosure. However, the technical solutions claimed in the present disclosure may be implemented even without these technical details and various changes and modifications made based on the following embodiments.

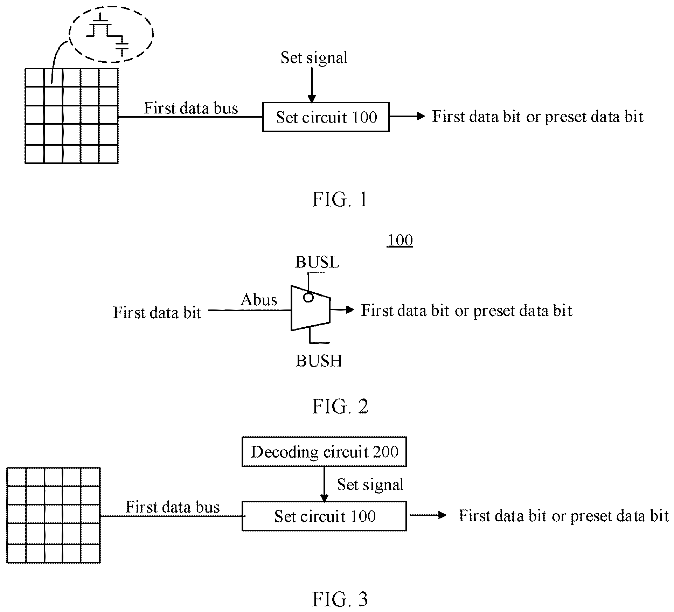

In an embodiment of the present disclosure, refer to FIG. 1, which is a schematic diagram of a composition structure of a memory according to an embodiment of the present disclosure. As shown in FIG. 1, the memory includes: a plurality of storage cells arranged in an array, configured such that when a storage cell is selected, data stored in the storage cell is read out from a bit line to a first data bus Abus; and a set circuit 100, connected to the first data bus Abus to receive a set signal, and configured to enable the first data bus Abus based on the set signal and output a first data bit when the memory is in a first mode, or disable the first data bus Abus based on the set signal and output a preset data bit when the memory is in a second mode, where the first mode is a normal read mode, and the second mode is a duty cycle training assist mode.

The storage cell includes a selection transistor and a capacitor, a gate of the selection transistor is connected to a word line, one end of the selection transistor is connected to the capacitor, and another end of the selection transistor is connected to the bit line. When the storage cell is selected, that is, when the memory receives a command and an address signal from a controller, and the storage cell of the corresponding address is selected for a read/write operation, the gate of the selection transistor receives a word line signal and is turned on, and data stored in the capacitor is read out from the bit line to the first data bus Abus, or the bit line receives data from the first data bus Abus and writes the data into the capacitor. It should be noted that the data read out from the bit line further needs to be amplified by a circuit such as a local sense amplifier (Local Sense Amplifier, Local SA) or a global sense amplifier (Global Sense Amplifier, Global SA), and transmitted to a peripheral circuit (an order of circuit modules through which the written data passes is reversed). The first data bus Abus in this embodiment of the present disclosure refers to a data line located in the peripheral circuit and electrically connected to the bit line. The data transmitted on the first data bus Abus is the data read out from the storage cell and amplified, that is, one data bit (data bit), which is generally logic 0 or logic 1. A person skilled in the art should know that data transmitted by a DRAM includes a plurality of data bits. For example, one piece of data transmitted in DDR5 may include 16 data bits (D0 to D15). DDR5 may include a plurality of parallel first data buses Abuses, and each first data bus Abus is used to transmit one data bit corresponding to one storage cell in a plurality of storage cells arranged in an array.

With continued reference to FIG. 1, the set circuit 100 is connected to the first data bus Abus to receive the set signal. When the memory is in the first mode, that is, the normal read mode, the first data bus Abus is enabled based on the set signal and the first data bit is output. When the memory is in the second mode, that is, the duty cycle training assist mode, the first data bus Abus is disabled based on the set signal and the preset data bit is output.

In the normal read mode, the first data bus Abus is enabled based on the set signal. In this case, the set circuit 100 is inactive, functioning as a transmission line to transmit the data on the first data bus Abus and output the first data bit. The first data bit refers to the data output in the normal read mode, that is, the data read out from the storage cell. In the duty cycle training assist mode, the first data bus Abus is disabled based on the set signal. At this moment, the set circuit 100 is active, and a preset data bit is generated. The preset data bit refers to data output in the duty cycle training assist mode, that is, the memory generates a preset data pattern according to an instruction of the controller. In this way, the set circuit 100 is disposed on the first data bus Abus, and the first data bus Abus can be selectively enabled or disabled in different operation modes of the memory to output corresponding data. Therefore, the first data bus Abus is shared, and an area of the memory is saved. In addition, after the memory switches from the normal read mode to the duty cycle training assist mode, the first data bus Abus is disabled, and data in the normal read mode is no longer switched, thereby greatly reducing power consumption.

In an embodiment of the present disclosure, refer to FIG. 2, which is a schematic diagram of a composition structure of a set circuit 100 according to an embodiment of the present disclosure. As shown in FIG. 2, the set circuit 100 includes a setter, the set signal includes a first set signal BUSL and a second set signal BUSH, an input end of the setter is connected to the first data bus Abus, a first set end receives the first set signal BUSL, and a second set end receives the second set signal BUSH, where in the first mode, levels of the first set signal BUSL and the second set signal BUSH are different, or in the second mode, levels of the first set signal and the second set signal are the same.

One first data bus Abus is used as an example. Data in a storage cell that is read from a bit line is transmitted by using the first data bus Abus. It should be noted that the data herein refers to one data bit of data, that is, the first data bit. The set circuit 100 may be the setter. The input end of the setter is connected to the first data bus Abus, the first set end of the setter receives the first set signal BUSL, and the second set end of the setter receives the second set signal BUSH. In the first mode, that is, the normal read mode, the levels of the first set signal BUSL and the second set signal BUSH are different, that is, the first set signal BUSL may be at a high level (logic 1) and the second set signal BUSH may be at a low level (logic 0). In this case, the setter is inactive and equivalent to a transmission line, and the first data bit is normally read out through the first data bus Abus without any interference. In the second mode, that is, the duty cycle training assist mode, the levels of the first set signal BUSL and the second set signal BUSH are the same, that is, the first set signal BUSL and the second set signal BUSH may be at a high level (logic 1). In this case, the setter is active, and the output data is pulled to 0 by the setter, that is, the output preset data bit is equal to logic 0. Alternatively, the first set signal BUSL and the second set signal BUSH may be at a low level (logic 0). In this case, the setter is active, and the output data is pulled to 1 by the setter, that is, the output preset data bit is equal to logic 1. It may be understood that when the setter is active or inactive, the corresponding levels of the first set signal BUSL and the second set signal BUSH may vary in different cases. FIG. 2 shows only an example in which the first set signal BUSL is valid at a low level and the second set signal BUSH is valid at a high level.

In this way, the first set end of the setter is set to receive the first set signal BUSL, the second set end is set to receive the second set signal BUSH. Based on the first set signal BUSL and the second set signal BUSH, the setter becomes inactive in the first mode, the first data bus Abus is enabled, and the first data bit is output; and the setter becomes active in the second mode, the first data bus Abus is disabled, and the preset data bit is output. A level state of the preset data bit may be obtained by setting the levels of the first set signal BUSL and the second set signal BUSH. Therefore, different preset data bits can be generated by setting the levels of the first set signal BUSL and the second set signal BUSH, and then different preset data patterns can be generated to achieve duty cycle training.

A DRAM industry standard specifies that whether the DCA training assist mode is enabled and the preset data pattern may be obtained through decoding based on a register code of a mode register MR 42. As shown in Table 1 below, a plurality of register codes of the mode register MR 42 respectively indicate whether the DCA training assist mode is supported and preset data patterns corresponding to different DCA training assist modes. The mode register MR 42 includes an 8-bit register code OP[7:0].

OP[1:0] is used to indicate whether the memory supports the DCA training assist mode. If OP[1:0] = 00, it indicates that the memory does not support the DCA training assist mode. If OP[1:0] = 01, it indicates that the memory supports a DCA two-phase clock training assist mode, that is, the DCA training assist mode I. If OP[1:0] = 10, it indicates that the memory supports a DCA four-phase clock training assist mode, that is, the DCA training assist mode II (OP[1:0] = 11, reserved for future use, RFU. The following RFU is the same as the RFU herein and is not described again).

OP[3:2] is used to indicate that the memory is in the DCA training assist mode I. If OP[3:2] = 00, it indicates that the memory is in a default state. If OP[3:2] = 01, it indicates that memory data synchronized with an IBCLK is masked, that is, the data is aligned with the ICLK. If OP[3:2] = 10, it indicates that memory data synchronized with the ICLK is masked, that is, the data is aligned with the IBCLK.

OP[6:4] is used to indicate that the memory is in the DCA training assist mode II. If OP[6:4] = 000, it indicates that the memory is in the default state. If OP[6:4] = 001, it indicates that the preset data pattern for memory write/read is 0001. If OP[6:4] = 010, it indicates that the preset data pattern for memory write/read is 0011. If OP[6:4] = 011, it indicates that the preset data pattern for memory write/read is 0111. If OP[6:4] = 100, it indicates that the preset data pattern for memory write/read is 1000. If OP[6:4] = 101, it indicates that the preset data pattern for memory write/read is 1100. If OP[6:4] = 110, it indicates that the preset data pattern for memory write/read is 1110.

OP[7] is used to indicate whether the DCA training assist mode is supported in a current memory read state. If OP[7] = 0, it indicates that the DCA training assist mode II is not supported in the memory read state. If OP[7] = 1, it indicates that the DCA training assist mode II is supported in the memory read state.

**Table 1**

| Function | Register Type | Operand | Data |
|---|---|---|---|
| DCA Types Supported | R | OP[1:0] | 00B: Device does not support DCA |
| | | | 01B: Device supports DCA for single/two-phase internal clock(s) |
| | | | 10B: Device supports DCA for 4-phase internal clocks |
| | | | 11B: RFU |
| DCA Training | R/W | OP[3:2] | 00B: Disable (default) |
| Assist Mode I | | | 01B: MRR (or Read) synchronized with IBCLK is blocked |
| | | | 10B: MRR (or Read) synchronized with ICLK is blocked |
| | | | 11B: RFU |
| DCA Training Assist Mode II | R/W | OP[6:4] | 000B: Disable (default) |
| | | | 001B: DQ fires 0001 data pattern |
| | | | 010B: DQ fires 0011 data pattern |
| | | | 011B: DQ fires 0111 data pattern |
| | | | 100B: DQ fires 1000 data pattern |
| | | | 101B: DQ fires 1100 data pattern |
| | | | 110B: DQ fires 1110 data pattern |
| | SR/W | OP[7] | DRAM Status Read (SR) |
| | | | 0B: DCA Training Assist Mode II is not supported |
| | | | 1B: DCA Training Assist Mode II is supported |

A register code OP[7:0] = 10010010 of the mode register MR 42 is used as an example. OP[1:0] = 10, OP[3:2] = 00, OP[6:4] = 001, and OP[7] = 1. Therefore, the memory correspondingly enables the DCA training assist mode II and generates a preset data pattern 0001.

In an embodiment of the present disclosure, refer to FIG. 3, which is a schematic diagram of another composition structure of a memory according to an embodiment of the present disclosure. As shown in FIG. 3, the memory further includes a decoding circuit 200, configured to receive a register code of a mode register and perform decoding to generate the set signal.

The decoding circuit 200 may receive a register code OP[6:4] of the mode register MR 42, and perform decoding to generate a set signal. When the memory is in the second mode, that is, the DCA training assist mode, the set circuit 100 is activated based on the set signal, the first data bus Abus is disabled, and a preset data bit is output, where the preset data bit corresponds to a bit in the preset data pattern. The register code OP[6:4] includes three bits. Therefore, the decoding circuit 200 can perform decoding and generate set signals with eight different level combinations based on the register code OP[6:4], thereby generating preset data bits the same as the preset data pattern.

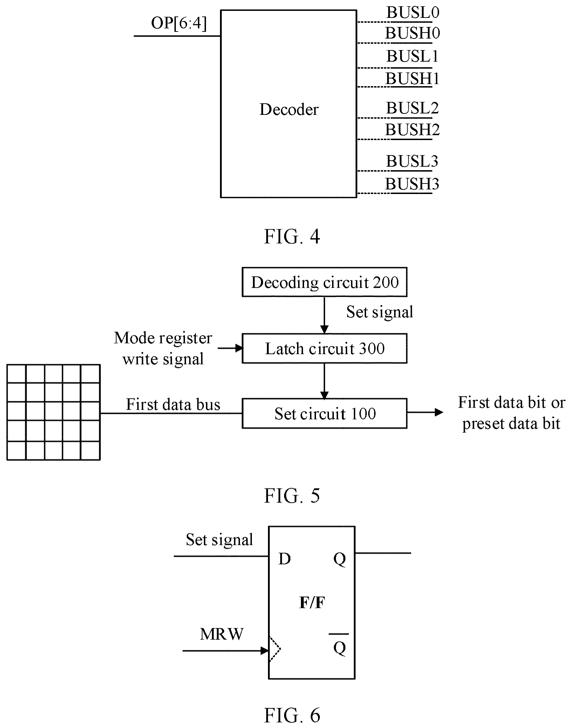

Refer to FIG. 4, which shows a schematic diagram of a composition structure of a decoding circuit 200 according to an embodiment of the present disclosure. As shown in FIG. 4, the decoding circuit 200 includes a decoder. The decoder receives the register code OP[6:4] of the mode register MR 42, and performs decoding to generate set signals BUSL0/BUSH0, BUSL1/BUSH1, BUSL2/BUSH2, and BUSL3/BUSH3. The decoder may be a 3-to-8 decoder, which receives a three-bit register code and performs decoding to generate eight data bits. Every two data bits correspond to one set signal, where one data bit corresponds to the first set signal BUSL, and the other data bit corresponds to the second set signal BUSH. As mentioned above, a level of one bit in the preset data pattern, that is, a level of the preset data bit, may be generated based on the levels of the first set signal BUSL and the second set signal BUSH.

For example, when the register code OP[6:4] of the mode register MR 42 is 000, the decoder performs decoding to generate the set signals BUSLO = BUSL1 = BUSL2 = BUSL3 = 1, and BUSHO = BUSH1 = BUSH2 = BUSH3 = 0. With reference to FIG. 2 and FIG. 4, in this case, the first set end of the setter receives 1, and the second set end of the setter receives 0, the set circuit is inactive, and the first data bit is read out normally through the first data bus Abus without any interference. When the register code OP[6:4] of the mode register MR 42 is 001, the decoder performs decoding to generate the set signals BUSL0 = BUSH0 = 0, BUSL1 = BUSH1 = 1, BUSL2 = BUSH2 = 1, and BUSL3 = BUSH3 = 1. In this case, a group of four set circuits 200 is used as an example. A first set end of a first set circuit 200 receives 0, a second set end thereof receives 0, the set circuit 200 is active, and output data is pulled to 1. A first set end of any one of remaining three set circuits 200 receives 1, a second set end thereof receives 1, the set circuit 200 is active, output data is pulled to 0, and a generated data pattern is 0001, which is equal to the preset data pattern. Therefore, the controller can distinguish between the ICLK and the IBCLK based on the first bit or the third bit sampled by a clock signal, in the data pattern generated by the memory, and then can perform DCA training and align a four-phase clock. It should be noted that the DCA training, the received register code, and the generated preset data pattern are all for the DCA training assist mode II, that is, four-phase clock training. A correspondence between the register code OP[6:4] of the mode register MR 42 and the set signal generated through decoding is shown in Table 2 below. It should be noted that there may be a variety of correspondences between the register code and the level of the set signal. The case in Table 2 is used only as an example to illustrate one of the correspondences.

**Table 2**

| OP[6:4] | BUSL0 | BUSH0 | BUSL1 | BUSH1 | BUSL2 | BUSH2 | BUSL3 | BUSH3 |
|---|---|---|---|---|---|---|---|---|
| 000 | 1 | 0 | 1 | 0 | 1 | 0 | 1 | 0 |
| 001 | 0 | 0 | 1 | 1 | 1 | 1 | 1 | 1 |
| 010 | 0 | 0 | 0 | 0 | 1 | 1 | 1 | 1 |
| 011 | 0 | 0 | 0 | 0 | 0 | 0 | 1 | 1 |
| 100 | 1 | 1 | 1 | 1 | 1 | 1 | 0 | 0 |
| 101 | 1 | 1 | 1 | 1 | 0 | 0 | 0 | 0 |
| 110 | 1 | 1 | 0 | 0 | 0 | 0 | 0 | 0 |

In an embodiment of the present disclosure, refer to FIG. 5, which is a schematic diagram of another composition structure of a memory according to an embodiment of the present disclosure. As shown in FIG. 5, the memory further includes a latch circuit 300, connected to the decoding circuit 200 to receive a mode register write signal MRW, and configured such that when the mode register write signal MRW is valid, the latch circuit 300 is controlled to output the set signal, or that when the mode register write signal MRW is invalid, the latch circuit 300 is controlled to latch the set signal.

As can be learned above, the set signal generated by the decoding circuit 200 is to be transmitted to the set circuit 100. When the memory is in the second mode, that is, the duty cycle training assist mode, the set circuit 100 is active and generates the preset data bit in the preset data pattern based on the set signal. Based on a change of the register code of the mode register, the decoding circuit 200 also performs decoding to generate corresponding different set signals. Therefore, the latch circuit 300 is added between the decoding circuit 200 and the set circuit 100. The latch circuit 300 receives the mode register write signal MRW. The latch circuit 300 is controlled to trigger the output of the latest set signal only when the mode register write signal MRW is valid. When the mode register write signal MRW is invalid, the latch circuit 300 is controlled to latch the set signal, that is, the set signal received by the set circuit 100 remains unchanged. A purpose of doing this is to trigger the latch circuit 300 to operate and output a value of the set signal generated through decoding by the decoding circuit 200, only when the mode register write signal MRW is valid, that is, when the register code OP[6:4] of the mode register MR 42 changes. In this way, the subsequent set circuit 100 is controlled to receive the set signal, switching of the corresponding preset data bit is not affected, and occurrence of glitches is reduced.

Refer to FIG. 6, which shows a schematic diagram of a composition structure of a latch circuit 300 according to an embodiment of the present disclosure. As shown in FIG. 6, the latch circuit 300 includes a latch, a signal input end of the latch receives the set signal generated by the decoding circuit 200, and a clock end of the latch receives the mode register write signal MRW. When the mode register write signal MRW is valid, an output end of the latch outputs the set signal. When the mode register write signal MRW is invalid, the output end of the latch has no output. The latch may be a D flip-flop.

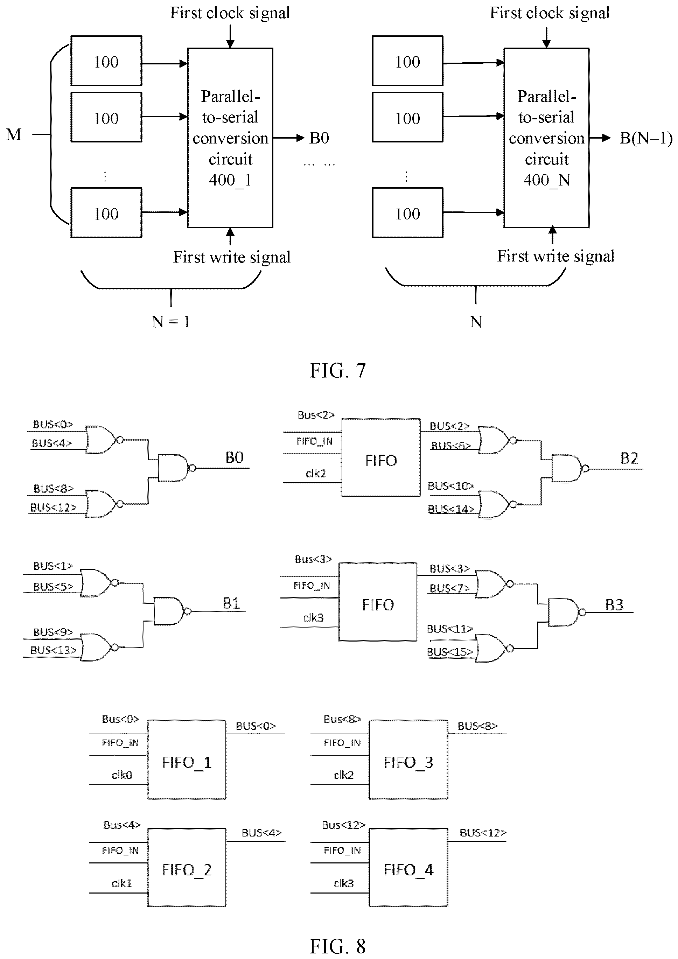

In an embodiment of the present disclosure, refer to FIG. 7, which is a schematic diagram of another composition structure of a memory according to an embodiment of the present disclosure. As shown in FIG. 7, the memory further includes N parallel-to-serial conversion circuits, each of which is correspondingly connected to M set circuits 100 and configured to receive data bits output by the M set circuits 100 and sample the data bits based on a first clock signal, and perform logic processing to generate second data, each piece of the second data including M serial data bits, where N and M are even integers.

A first parallel-to-serial conversion circuit 400_1 is connected to M set circuits 100, and configured to receive data bits output by the M set circuits 100 and sample the data bits based on the first clock signal, and perform logic processing to generate second data B0. An N^{th} parallel-to-serial conversion circuit 400_N is connected to M set circuits 100, and configured to receive data bits output by the M set circuits 100 and sample the data bits based on the first clock signal, and perform logic processing to generate second data B(N-1). For ease of distinguishing, the second data generated by the parallel-to-serial conversion circuits is sorted and named herein. The second data output by the first parallel-to-serial conversion circuit is B0, second data output by a second parallel-to-serial conversion circuit is B1, and so on, and the second data output by the N^{th} parallel-to-serial conversion circuit is B(N-1). Each piece of the second data includes M serial data bits. It should be noted that the second data herein refers to the data output by the parallel-to-serial conversion circuit, and not data finally output by the memory to an input/output interface. Herein, N pieces of second data are output in parallel. Therefore, it should be understood by a person of ordinary skill in the art that the N pieces of the second data need to undergo at least one parallel-to-serial operation before the data can be transmitted to the input/output interface to achieve the final data output. For each parallel-to-serial conversion circuit, the connected M set circuits 100 are also in parallel. For the N parallel-to-serial conversion circuits, M set circuits correspondingly connected to each parallel-to-serial conversion circuit are different from those connected to any other parallel-to-serial conversion circuit. The term "first", "second", or "N^{th}" herein does not constitute a limitation on an output order.

In an embodiment of the present disclosure, with continued reference to FIG. 7, a clock cycle of the first clock signal is M times a clock cycle of a system clock signal, and in each of the parallel-to-serial conversion circuits, valid pulse periods of first clock signals received by the M set circuits 100 do not overlap each other.

The first clock signal may be an internal clock signal generated based on the system clock signal. The system clock signal refers to a clock signal sent by the controller to the DRAM, and corresponds to an operating frequency of the DRAM. Generally, an operating frequency corresponding to a system clock signal of a fifth generation double rate synchronous dynamic random access memory (DDR5) is 6400 MHz, and a clock cycle of a system clock signal is approximately 312.5 ps. If the clock cycle of the system clock signal is excessively short, and a sampling window corresponding to a valid pulse period is excessively small, the sampling time is likely to be insufficient, resulting in sampling failure or mis-sampling. Therefore, an internal clock signal with a widened valid pulse can be generated based on the system clock signal. For example, a valid pulse width of the first clock signal may be twice a valid pulse width of the system clock signal. In this way, a sufficient sampling window can be ensured, and misreading or miswriting is not likely to occur.

Because the second data generated by the parallel-to-serial conversion circuit based on sampling of the first clock signal includes M serial data bits, the clock cycle of the first clock signal can be M times the clock cycle of the system clock signal, and in each parallel-to-serial conversion circuit, the valid pulse periods of the first clock signals received by the M set circuits 100 do not overlap each other. Therefore, the following can be achieved: Within one clock cycle of the first clock signal, or within M clock cycles of the system clock signal, N pieces of second data are output in parallel, each piece of the second data includes M data bits output in series, and each data bit corresponds to one clock cycle of the system clock signal.

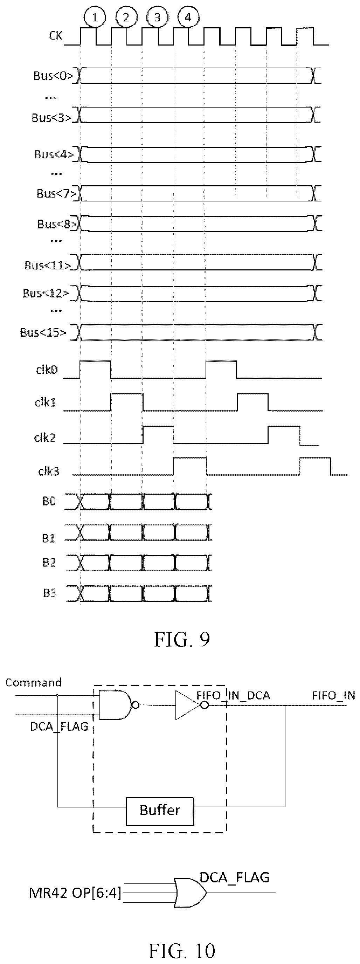

Refer to FIG. 8, which shows a schematic diagram of a composition structure of a parallel-to-serial conversion circuit according to an embodiment of the present disclosure. FIG. 9 is a schematic timing diagram corresponding to the parallel-to-serial conversion circuit in FIG. 8. As shown in FIG. 8, the memory includes four parallel-to-serial conversion circuits 400_1 to 400_4, where each parallel-to-serial conversion circuit includes four buffers (First In First Out, FIFO) and corresponding logic processing gate circuits, is connected to four set circuits 100 (not shown in the figure), and is configured to receive data bits output by the four set circuits 100 and sample the data bits based on first clock signals clk0, clkl, clk2, and clk3, and perform logic processing to generate second data B0, B1, B2, and B3. Each piece of the second data includes M serial data bits, where N and M are even integers.

For a first parallel-to-serial conversion circuit 400_1, a signal input end of a first buffer FIFO_1 receives a data bit Bus<0> output by a first set circuit, a clock end of the first buffer FIFO_1 receives a first clock signal clk0, and an output end of the first buffer FIFO_1 outputs an intermediate data bit BUS<0>. A signal input end of a second buffer FIFO_2 receives a data bit Bus<4> output by a second set circuit, a clock end of the second buffer FIFO_2 receives a first clock signal clkl, and an output end of the second buffer FIFO_2 outputs an intermediate data bit BUS<4>. A signal input end of a third buffer FIFO_3 receives a data bit Bus<8> output by a third set circuit, a clock end of the third buffer FIFO_3 receives a first clock signal clk2, and an output end of the third buffer FIFO_3 outputs an intermediate data bit BUS<8>. A signal input end of a fourth buffer FIFO_4 receives a data bit BUS<12> output by a fourth set circuit, a clock end of the fourth buffer FIFO_4 receives a first clock signal clk3, and an output end of the fourth buffer FIFO_4 outputs an intermediate data bit BUS<12>. A first input end of a NOR gate receives the intermediate data bit BUS<0>, a second input end thereof receives the intermediate data bit BUS<4>, and an output end thereof is connected to a first input end of a NAND gate. A first input end of another NOR gate receives the intermediate data bit BUS<8>, a second input end thereof receives the intermediate data bit BUS<12>, and an output end thereof is connected to a second input end of the NAND gate. An output end of the NAND gate outputs second data B0, where the second data B0 includes 4 serial data bits, that is, BUS<0, 4, 8, 12>. It should be noted that the first, second, third, and fourth herein are named in order of appearance, and do not constitute any substantial limitation on an actual connection relationship.

For a second parallel-to-serial conversion circuit 400_2, a signal input end of a first buffer FIFO_1 receives a data bit Bus<1> output by a first set circuit, a clock end of the first buffer FIFO_1 receives a first clock signal clk0, and an output end of the first buffer FIFO_1 outputs an intermediate data bit BUS<1>. A signal input end of a second buffer FIFO_2 receives a data bit Bus<5> output by a second set circuit, a clock end of the second buffer FIFO_2 receives a first clock signal clkl, and an output end of the second buffer FIFO_2 outputs an intermediate data bit BUS<5>. A signal input end of a third buffer FIFO_3 receives a data bit Bus<9> output by a third set circuit, a clock end of the third buffer FIFO_3 receives a first clock signal clk2, and an output end of the third buffer FIFO_3 outputs an intermediate data bit BUS<9>. A signal input end of a fourth buffer FIFO_4 receives a data bit Bus<13> output by a fourth set circuit, a clock end of the fourth buffer FIFO_4 receives a first clock signal clk3, and an output end of the fourth buffer FIFO_4 outputs an intermediate data bit BUS<13>. A first input end of a NOR gate receives the intermediate data bit BUS<1>, a second input end thereof receives the intermediate data bit BUS<5>, and an output end thereof is connected to a first input end of a NAND gate. A first input end of another NOR gate receives the intermediate data bit BUS<9>, a second input end thereof receives the intermediate data bit BUS<13>, and an output end thereof is connected to a second input end of the NAND gate. An output end of the NAND gate outputs second data B1, where the second data B1 includes 4 serial data bits, that is, Bus<1, 5, 9, 13>. For clarity in the illustration, the buffers in the second, third, and fourth parallel-to-serial conversion circuits are not shown in FIG. 9, but this does not impose any limitation on actual composition structures of the circuits.

For a third parallel-to-serial conversion circuit 400_3, a signal input end of a first buffer FIFO_1 receives a data bit Bus<2> output by a first set circuit, a clock end of the first buffer FIFO_1 receives a first clock signal clk0, and an output end of the first buffer FIFO_1 outputs an intermediate data bit BUS<2>. A signal input end of a second buffer FIFO_2 receives a data bit Bus<6> output by a second set circuit, a clock end of the second buffer FIFO_2 receives a first clock signal clkl, and an output end of the second buffer FIFO_2 outputs an intermediate data bit BUS<6>. A signal input end of a third buffer FIFO_3 receives a data bit Bus<10> output by a third set circuit, a clock end of the third buffer FIFO_3 receives a first clock signal clk2, and an output end of the third buffer FIFO_3 outputs an intermediate data bit BUS<10>. A signal input end of a fourth buffer FIFO_4 receives a data bit Bus<14> output by a fourth set circuit, a clock end of the fourth buffer FIFO_4 receives a first clock signal clk3, and an output end of the fourth buffer FIFO_4 outputs an intermediate data bit BUS<14>. A first input end of a NOR gate receives the intermediate data bit BUS<2>, a second input end thereof receives the intermediate data bit BUS<6>, and an output end thereof is connected to a first input end of a NAND gate. A first input end of another NOR gate receives the intermediate data bit BUS<10>, a second input end thereof receives the intermediate data bit BUS<14>, and an output end thereof is connected to a second input end of the NAND gate. An output end of the NAND gate outputs second data B2, where the second data B2 includes 4 serial data bits, that is, Bus<2, 6, 10, 14>.

For a fourth parallel-to-serial conversion circuit 400_4, a signal input end of a first buffer FIFO_1 receives a data bit Bus<3> output by a first set circuit, a clock end of the first buffer FIFO_1 receives a first clock signal clk0, and an output end of the first buffer FIFO_1 outputs an intermediate data bit BUS<3>. A signal input end of a second buffer FIFO_2 receives a data bit Bus<7> output by a second set circuit, a clock end of the second buffer FIFO_2 receives a first clock signal clkl, and an output end of the second buffer FIFO_2 outputs an intermediate data bit BUS<7>. A signal input end of a third buffer FIFO_3 receives a data bit Bus<11> output by a third set circuit, a clock end of the third buffer FIFO_3 receives a first clock signal clk2, and an output end of the third buffer FIFO_3 outputs an intermediate data bit BUS<11>. A signal input end of a fourth buffer FIFO_4 receives a data bit Bus<15> output by a fourth set circuit, a clock end of the fourth buffer FIFO_4 receives a first clock signal clk3, and an output end of the fourth buffer FIFO_4 outputs an intermediate data bit BUS<15>. A first input end of a NOR gate receives the intermediate data bit BUS<3>, a second input end thereof receives the intermediate data bit BUS<7>, and an output end thereof is connected to a first input end of a NAND gate. A first input end of another NOR gate receives the intermediate data bit BUS<11>, a second input end thereof receives the intermediate data bit BUS<15>, and an output end thereof is connected to a second input end of the NAND gate. An output end of the NAND gate outputs second data B3, where the second data B3 includes 4 serial data bits, that is, Bus<3, 7, 11, 15>. It should be noted that N = 4 and M = 4 are used as an example herein, that is, 16 parallel data bits Bus<0> to Bus<15> output by 16 first data buses Abus are processed by four parallel-to-serial conversion circuits to generate four pieces of parallel second data B0 to B3, each of which includes four serial output data bits. In practice, there may be multiple scenarios for N and M, such as N = 4 and M = 2, meaning 8-to-2 conversion, or N = 6 and M = 4, meaning 24-to-4 conversion.

Clock cycles of the first clock signals clk0, clkl, clk2, and clk3 are four times the clock cycle of the system clock signal CK, and in each parallel-to-serial conversion circuit, valid pulse periods of the first clock signals clk0, clkl, clk2, and clk3 correspondingly received by the four set circuits 100 do not overlap each other. As shown in FIG. 9, the valid pulse width of the first clock signal may be twice the valid pulse width of the system clock signal CK. A rising edge of a first valid pulse of the first clock signal clk0 is aligned with a rising edge of a first valid pulse of the system clock signal CK. A falling edge of the first valid pulse of the first clock signal clk0 is aligned with a rising edge of a second valid pulse of the system clock signal CK and a rising edge of a first valid pulse of the first clock signal clk1. A falling edge of the first valid pulse of the first clock signal clk1 is aligned with a rising edge of a third valid pulse of the system clock signal CK and a rising edge of a first valid pulse of the first clock signal clk2. A falling edge of the first valid pulse of the first clock signal clk2 is aligned with a rising edge of a fourth valid pulse of the system clock signal CK and a rising edge of a first valid pulse of the first clock signal clk3. A falling edge of the first valid pulse of the first clock signal clk3 is aligned with a rising edge of a fifth valid pulse of the system clock signal CK and a rising edge of a second valid pulse of the first clock signal clk0. In this way, only one first clock signal is valid at a same moment, and four serial data bits are output. It should be noted that the alignment and non-overlapping mentioned herein are both for ideal cases. In actual circuits, due to existence of delays, the first clock signals may overlap each other.

With reference to FIG. 9 and Table 3 below, in a first clock cycle of the system clock signal CK, the four parallel-to-serial conversion circuits correspondingly output the second data B0B1B2B3 = Bus<0 to 3>; in a second clock cycle of the system clock signal CK, the four parallel-to-serial conversion circuits correspondingly output the second data B0B1B2B3 = Bus<4 to 7>; in a third clock cycle of the system clock signal CK, the four parallel-to-serial conversion circuits correspondingly output the second data B0B1B2B3 = Bus<8 to 11>; and in a fourth clock cycle of the system clock signal CK, the four parallel-to-serial conversion circuits correspondingly output the second data B0B1B2B3 = Bus<12 to 15>.

**Table 3**

| CK | 1 | 2 | 3 | 4 |
|---|---|---|---|---|
| B0 | Bus<0> | Bus<4> | Bus<8> | Bus<12> |
| B1 | Bus<1> | Bus<5> | Bus<9> | Bus<13> |
| B2 | Bus<2> | Bus<6> | Bus<10> | Bus<14> |
| B3 | Bus<3> | Bus<7> | Bus<11> | Bus<15> |

In an embodiment of the present disclosure, with reference to Table 2 and Table 3, when the memory is in the second mode, levels of the M serial data bits in each piece of the second data are the same, and N is equal to the number of bits in the preset data pattern. As shown in Table 2, when the memory is in the second mode, that is, the duty cycle training assist mode, the decoding circuit 200 generates a set signal based on the register code OP[6:4] of the mode register MR 42, the set circuit 100 is activated based on the set signal, and a preset data bit is output. Because the preset data pattern includes four bits, four parallel-to-serial conversion circuits are required to generate four pieces of second data. An output of the four pieces of the second data at the first valid pulse of the system clock signal is equal to the preset data pattern (a subsequent conversion circuit is also required). For the 16 parallel first data buses Abuses, when the memory is in the first mode, the second data generated by each parallel-to-serial conversion circuit is data read out from a storage cell. When the memory is in the second mode, the second data B0 generated by the first parallel-to-serial conversion circuit 400_1 is Bus<0> = Bus<4> = Bus<8> = Bus<12>, the second data B1 generated by the second parallel-to-serial conversion circuit 400_2 is Bus<1> = Bus<5> = Bus<9> = Bus<13>, the second data B2 generated by the third parallel-to-serial conversion circuit 400_3 is Bus<2> = Bus<6> = Bus<10> = Bus<14>, and the second data B3 generated by the fourth parallel-to-serial conversion circuit 400_4 is Bus<3> = Bus<7> = Bus<11> = Bus<15>. As the register code OP[6:4] of the mode register MR 42 controls generation of different set signals, the set circuit 100 is controlled to generate different preset data bits, thereby generating different data patterns.

In an embodiment of the present disclosure, with continued reference to FIG. 7 and FIG. 8, the parallel-to-serial conversion circuit further receives a first write signal FIFO_IN, and is configured such that when the first write signal FIFO_IN is valid, the parallel-to-serial conversion circuit triggers the generation of the second data.

As shown in FIG. 8, an input end of a buffer FIFO also receives a first write signal FIFO_IN. The buffer FIFO operates only when the first write signal FIFO_IN is valid, writing a data bit output by the set circuit 100 into the buffer FIFO, performing sampling, and outputting an intermediate data bit. The first write signal FIFO_IN may be generated based on a command received by the memory, such as a read command or a mode register read command.

Refer to FIG. 10, which shows a schematic diagram of a composition structure of a first write signal generation circuit according to an embodiment of the present disclosure. As shown in FIG. 10, an input end of an OR gate receives the register code OP[6:4] of the mode register MR 42, and an output end of the OR gate outputs a duty cycle training assist mode identification signal DCA_FLAG. A first input end of a NAND gate receives a command signal command, and a second input end thereof receives a duty cycle training assist mode identification signal DCA_FLAG. An output end of the NAND gate is connected to an inverter, and an output end of the inverter outputs a first duty cycle write signal FIFO_IN_DCA. The command signal command is also connected to a plurality of buffers Buffer, and an output end of a buffer Buffer is connected to the output end of the inverter to output a first write signal FIFO_IN.

As shown in Table 1, if the memory does not support the duty cycle training assist mode (the duty cycle training assist mode II is used as an example in the present disclosure), the register code OP[6:4] of the mode register MR 42 is 000, that is, the OR gate outputs the duty cycle training assist mode identification signal DCA_FLAG as 0, and the first duty cycle write signal FIFO_IN_DCA generated after logic processing is also 0, that is, no data is written into the buffer FIFO. If the memory is in the second mode, that is, the duty cycle training assist mode, at least one bit of the register code OP[6:4] of the mode register MR 42 is 1, that is, the OR gate outputs the duty cycle training assist mode identification signal DCA_FLAG as 1, and the memory receives the corresponding command signal command in this case, and the first duty cycle write signal FIFO_IN_DCA generated after logic processing is also 1. In this case, the buffer FIFO operates normally and receives the data bit (preset data bit) output by the set circuit 100. It should be noted that if the memory does not support the duty cycle training assist mode, the register code OP[6:4] of the mode register MR 42 is 000, but the memory is in the first mode, that is, the normal read mode; the duty cycle training assist mode identification signal DCA_FLAG output by the OR gate is 0, but the command signal command is valid; the first duty cycle write signal FIFO_IN_DCA generated after logic processing is 0, but the first write signal FIFO_IN is 1; and the buffer FIFO operates normally and receives the data bit (first data bit) output by the set circuit 100.

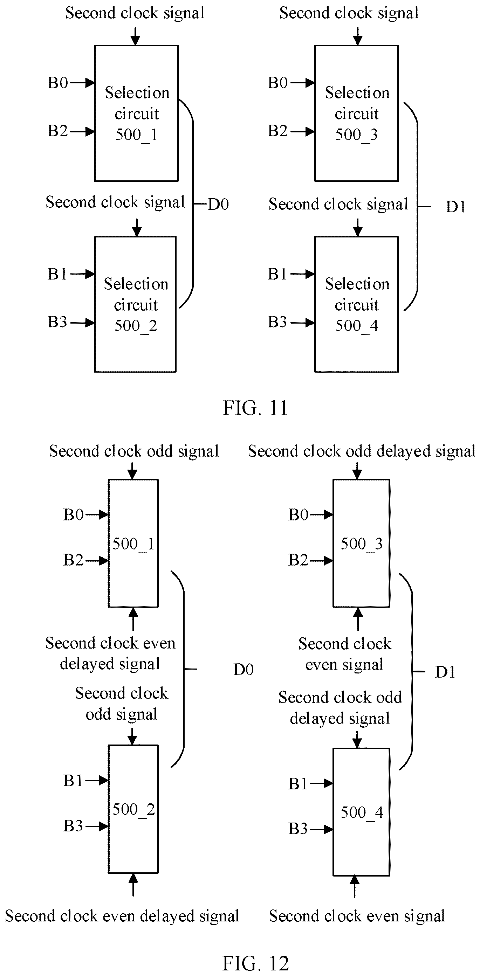

In an embodiment of the present disclosure, refer to FIG. 11, which is a schematic diagram of another composition structure of a memory according to an embodiment of the present disclosure. As shown in FIG. 11, the memory further includes N selection circuits, each of which is connected to two of the parallel-to-serial conversion circuits to receive the corresponding second data and is configured as follows: when the memory is in the first mode, the second data output by N/2 of the selection circuits in an odd mode is the same as the second data output by other N/2 of the selection circuits in an even mode; and when the memory is in the second mode, the second data output by the N/2 of the selection circuits in the odd mode is different from the second data output by the other N/2 of the selection circuits in the even mode, where two parallel-to-serial conversion circuits connected to each of the N/2 selection circuits are the same as two parallel-to-serial conversion circuits connected to a corresponding one of the other N/2 selection circuits.

Using N = 4 and N/2 = 2 as an example, the memory may include four selection circuits 500_1 to 500_4, each of which is connected to two parallel-to-serial conversion circuits (not shown in the figure) to receive corresponding second data.

When the memory is in the first mode, that is, the normal read mode, the second data output by two selection circuits in the odd mode is the same as the second data output by other two selection circuits in the even mode. When the memory is in the second mode, that is, the duty cycle training assist mode, the second data output by the two selection circuits in the odd mode is different from the second data output by the other two selection circuits in the even mode. Two parallel-to-serial conversion circuits connected to either of the two selection circuits are the same as two parallel-to-serial conversion circuits connected to a corresponding one of the other two selection circuits.

Herein, division of the four selection circuits into the two selection circuits and the other two selection circuits may include a plurality of combinations. For example, the two selection circuits may be the first selection circuit 500_1 and the second selection circuit 500_2, and the other two selection circuits are correspondingly the third selection circuit 500_3 and the fourth selection circuit 500_4. Alternatively, the two selection circuits may be the first selection circuit 500_1 and the third selection circuit 500_3, and the other two selection circuits are correspondingly the second selection circuit 500_2 and the fourth selection circuit 500_4. Alternatively, the two selection circuits may be the first selection circuit 500_1 and the fourth selection circuit 500_4, and the other two selection circuits are correspondingly the second selection circuit 500_2 and the third selection circuit 500_3.

In an embodiment of the present disclosure, with continued reference to FIG. 11, the selection circuits are configured as follows: when the memory is in the first mode, the second data output by first N/2 of the selection circuits in the odd mode is the same as the second data output by last N/2 of the selection circuits in the even mode; and when the memory is in the second mode, the second data output by the first N/2 of the selection circuits in the odd mode is different from the second data output by the last N/2 of the selection circuits in the even mode, where two parallel-to-serial conversion circuits connected to each of the first N/2 selection circuits are the same as two parallel-to-serial conversion circuits connected to a corresponding one of the last N/2 selection circuits.

An example in which the first two selection circuits are the first selection circuit 500_1 and the second selection circuit 500_2, and the last two selection circuits are the third selection circuit 500_3 and the fourth selection circuit 500_4 is used for description. When the memory is in the first mode, the second data output by the first selection circuit 500_1 and the second selection circuit 500_2 in the odd mode is the same as the second data output by the third selection circuit 500_3 and the fourth selection circuit 500_4 in the even mode. When the memory is in the second mode, the second data output by the first selection circuit 500_1 and the second selection circuit 500_2 in the odd mode is different from the second data output by the third selection circuit 500_3 and the fourth selection circuit 500_4 in the even mode. Two parallel-to-serial conversion circuits connected to the first selection circuit 500_1 are the same as two parallel-to-serial conversion circuits connected to the third selection circuit 500_3. Two parallel-to-serial conversion circuits connected to the second selection circuit 500_2 are the same as two parallel-to-serial conversion circuits connected to the fourth selection circuit 500_4. Details are described below with reference to FIG. 11 and Table 4 below.

The first selection circuit 500_1 and the third selection circuit 500_3 are connected to the first parallel-to-serial conversion circuit 400_1 and the third parallel-to-serial conversion circuit 400_3 (not shown in the figure) to receive the second data B0 output by the first parallel-to-serial conversion circuit 400_1 and the second data B2 output by the third parallel-to-serial conversion circuit 400_3. When the memory is in the first mode, the first selection circuit 500_1 outputs the second data B0 in the odd mode, and the third selection circuit 500_3 outputs the second data B0 in the even mode. When the memory is in the second mode, the first selection circuit 500_1 outputs the second data B0 in the odd mode, and the third selection circuit 500_3 outputs the second data B2 in the even mode. Alternatively, when the memory is in the first mode, the first selection circuit 500_1 outputs the second data B2 in the even mode, and the third selection circuit 500_3 outputs the second data B2 in the odd mode. When the memory is in the second mode, the first selection circuit 500_1 outputs the second data B0 in the even mode, and the third selection circuit 500_3 outputs the second data B2 in the odd mode.

The second selection circuit 500_2 and the fourth selection circuit 500_4 are connected to the second parallel-to-serial conversion circuit 400_2 and the fourth parallel-to-serial conversion circuit 400_4 (not shown in the figure) to receive the second data B1 output by the second parallel-to-serial conversion circuit 400_2 and the second data B3 output by the fourth parallel-to-serial conversion circuit 400_4. When the memory is in the first mode, the second selection circuit 500_2 outputs the second data B1 in the odd mode, and the fourth selection circuit 500_4 outputs the second data B1 in the even mode. When the memory is in the second mode, the second selection circuit 500_2 outputs the second data B1 in the odd mode, and the fourth selection circuit 500_4 outputs the second data B3 in the even mode. Alternatively, when the memory is in the first mode, the second selection circuit 500_2 outputs the second data B3 in the even mode, and the fourth selection circuit 500_4 outputs the second data B3 in the odd mode. When the memory is in the second mode, the second selection circuit 500_2 outputs the second data B1 in the even mode, and the fourth selection circuit 500_4 outputs the second data B3 in the odd mode.

**Table 4**

| | First mode | | Second mode | |
|---|---|---|---|---|
| | Odd mode | Even mode | Odd mode | Even mode |
| First selection circuit | B0 | B2 | B0 | B0 |
| Second selection circuit | B1 | B3 | B1 | B1 |
| Third selection circuit | B2 | B0 | B2 | B2 |
| Fourth selection circuit | B3 | B1 | B3 | B3 |

In an embodiment of the present disclosure, with continued reference to FIG. 11, the N selection circuits further receive second clock signals, perform sampling, and output two pieces of third data, each piece of the third data including N/2 pieces of parallel second data, where in the odd mode, the second clock signals received by the N/2 of the selection circuits are advanced by half a clock cycle compared with the second clock signals received by the other N/2 of the selection circuits; and in the even mode, the second clock signals received by the N/2 of the selection circuits are delayed by half a clock cycle compared with the second clock signals received by the other N/2 of the selection circuits.

As shown in FIG. 11, the four selection circuits receive the second clock signals, perform sampling, and output two pieces of third data D0 and D1, each of which includes two pieces of parallel second data. As shown in Table 5 below, the third data D0 is generated by the first selection circuit 500_1 and the second selection circuit 500_2. When the memory is in the first mode, the generated third data D0 is B0B1 in the odd mode or B2B3 in the even mode. When the memory is in the second mode, the generated third data D0 is B0B1 in the odd mode or B0B1 in the even mode. The third data D1 is generated by the third selection circuit 500_3 and the fourth selection circuit 500_4. When the memory is in the first mode, the generated third data D1 is B2B3 in the odd mode or B0B1 in the even mode. When the memory is in the second mode, the generated third data D1 is B2B3 in the odd mode or B2B3 in the even mode.

**Table 4**

| | First mode | | Second mode | |
|---|---|---|---|---|
| | Odd mode | Even mode | Odd mode | Even mode |
| Third data D0 | B0B1 | B2B3 | B0B1 | B0B1 |
| Third data D1 | B2B3 | B0B1 | B2B3 | B2B3 |

When the memory is in the first mode, because the second clock signals received by the first selection circuit 500_1 and the second selection circuit 500_2 are advanced by half a clock cycle compared with the second clock signals received by the third selection circuit 500_3 and the fourth selection circuit 500_4 in the odd mode, that is, the third data D0 is generated through sampling earlier than the third data D1, an order of the third data finally output by the N selection circuits is D0D1, that is, B0B1B2B3. Because the second clock signals received by the first selection circuit 500_1 and the second selection circuit 500_2 are delayed by half a clock cycle compared with the second clock signals received by the third selection circuit 500_3 and the fourth selection circuit 500_4 in the even mode, that is, the third data D0 is generated through sampling later than the third data D1, an order of the third data finally output by the N selection circuits is D1D0, that is, B0B1B2B3. In this way, when the memory is in the first mode, that is, the normal read mode, the output third data is the same in the odd/even mode, so that normal reading of the data can be achieved.

When the memory is in the second mode, because the second clock signals received by the first selection circuit 500_1 and the second selection circuit 500_2 are advanced by half a clock cycle compared with the second clock signals received by the third selection circuit 500_3 and the fourth selection circuit 500_4 in the odd mode, that is, the third data D0 is generated through sampling earlier than the third data D1, an order of the third data finally output by the N selection circuits is D0D1, that is, B0B1B2B3. Because the second clock signals received by the first selection circuit 500_1 and the second selection circuit 500_2 are delayed by half a clock cycle compared with the second clock signals received by the third selection circuit 500_3 and the fourth selection circuit 500_4 in the even mode, that is, the third data D0 is generated through sampling later than the third data D1, an order of the third data finally output by the N selection circuits is D1D0, that is, B2B3B0B1. In this way, when the memory is in the second mode, that is, the duty cycle training assist mode, the output third data is different in the odd/even mode. By comparing the output data with the preset data pattern, the controller can determine whether the output data is the first bit or the third bit, thereby determining whether the sampling clock corresponds to the ICLK or the IBCLK, and then adjusting the duty cycle of the system clock signal.

In an embodiment of the present disclosure, refer to FIG. 12, which is a schematic diagram of another composition structure of a memory according to an embodiment of the present disclosure. As shown in FIG. 12, the second clock signals include a second clock odd signal OCK and a second clock even signal ECK, clock cycles of the second clock odd signal OCK and the second clock even signal ECK are the same, and only one of the second clock odd signal OCK and the second clock even signal ECK is valid at a same moment. The odd mode corresponds to the second clock odd signal OCK being valid, and the even mode corresponds to the second clock even signal ECK being valid; in the odd mode, the N/2 of the selection circuits perform sampling based on the second clock odd signal OCK, and the other N/2 of the selection circuits perform sampling based on a second clock odd delayed signal OCKD; and in the even mode, the N/2 of the selection circuits perform sampling based on a second clock even delayed signal ECKD, and the other N/2 of the selection circuits perform sampling based on the second clock even signal ECK. The second clock odd delayed signal OCKD is delayed by half a clock cycle compared with the second clock odd signal OCK, and the second clock even delayed signal ECKD is delayed by half a clock cycle compared with the second clock even signal ECK.

The second clock signals include the second clock odd signal OCK and the second clock even signal ECK, both of which may be generated based on the system clock signal. An example in which the clock cycles of the second clock odd signal OCK and the second clock even signal ECK are the same and are twice the clock cycle of the system clock signal CK is used in the present disclosure. When the second clock odd signal OCK is valid, the second clock even signal ECK is masked. When the second clock even signal ECK is valid, the second clock odd signal OCK is masked. In this way, it can be ensured that only one valid pulse of the clock signal corresponds to the data being sampled at a same moment, and mis-sampling is avoided.

The first selection circuit 500_1 and the second selection circuit 500_2 receive the second clock odd signal OCK and the second clock even delayed signal ECKD. The third selection circuit 500_3 and the fourth selection circuit 500_4 receive the second clock odd delayed signal OCKD and the second clock even signal ECK. Therefore, the following can be achieved: In the odd mode, the first selection circuit 500_1 and the second selection circuit 500_2 perform sampling based on the valid second clock odd signal OCK and generate the third data D0, the third selection circuit 500_3 and the fourth selection circuit 500_4 perform sampling based on the valid second clock odd delayed signal OCKD and generate the third data D1, and the finally output third data is D0D1. In the even mode, the first selection circuit 500_1 and the second selection circuit 500_2 perform sampling based on the valid second clock even delayed signal ECKD and generate the third data D0, the third selection circuit 500_3 and the fourth selection circuit 500_4 perform sampling based on the valid second clock even signal ECK and generate the third data D1, and the finally output third data is D1D0. Therefore, the data output corresponding to the normal read mode or the duty cycle training assist mode can be implemented by setting different outputs of the third data D0 or D1 when the memory is in the first mode or the second mode.

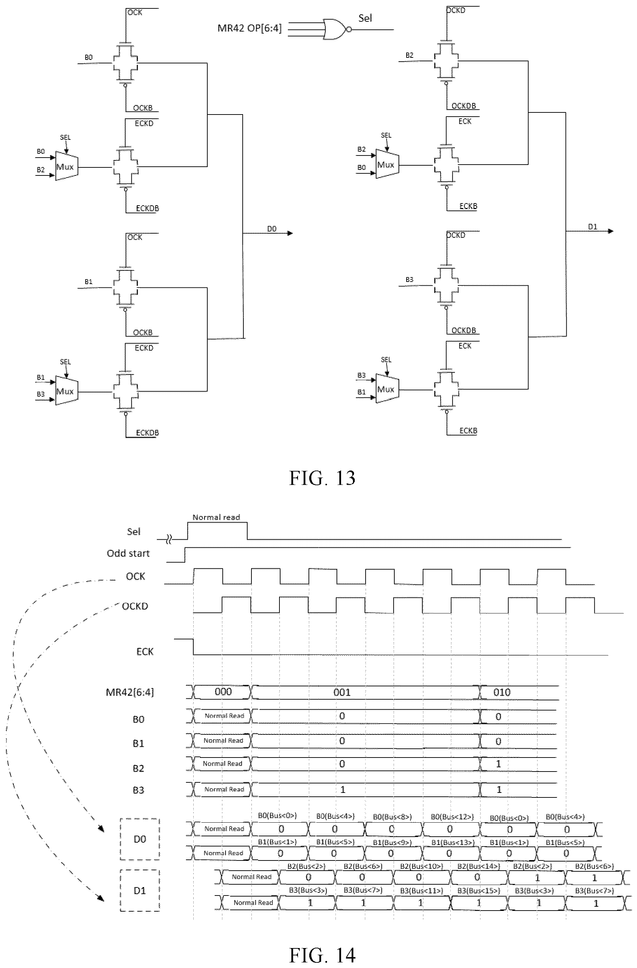

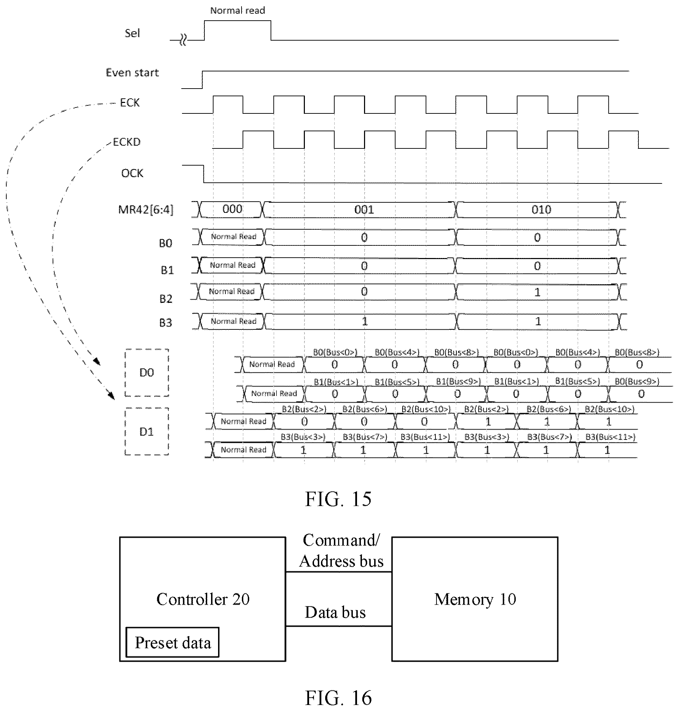

In an embodiment of the present disclosure, refer to FIG. 13, which is a schematic diagram of a composition structure of a selection circuit according to an embodiment of the present disclosure. FIG. 14 is a first schematic timing diagram corresponding to the selection circuit in FIG. 13 (odd mode). FIG. 15 is a second schematic timing diagram corresponding to the selection circuit in FIG. 13 (even mode). As shown in FIG. 13, each of the selection circuits includes an odd selection circuit and an even selection circuit, the odd selection circuit includes an odd sampling circuit connected to one of the parallel-to-serial conversion circuits to receive a first piece of the second data, and the even selection circuit includes a selector MUX and an even sampling circuit connected to two of the parallel-to-serial conversion circuits. One end of the selector MUX receives the first piece of the second data, another end of the selector MUX receives a second piece of the second data, a control end of the selector receives a first selection signal SEL, and the selection circuits are configured as follows: in the odd mode, the odd selection circuit receives the first piece of the second data and performs sampling based on the second clock odd signal OCK; and in the even mode, when the first selection signal SEL is at a first level, the selector MUX outputs the first piece of the second data, or when the first selection signal SEL is at a second level, the selector MUX outputs the second piece of the second data, and the even sampling circuit performs sampling based on the second clock even delayed signal ECKD. Alternatively, in the odd mode, the odd selection circuit receives the first piece of the second data and performs sampling based on the second clock odd delayed signal OCKD; and in the even mode, when the first selection signal SEL is at a first level, the selector MUX outputs the first piece of the second data, or when the first selection signal SEL is at a second level, the selector MUX outputs the second piece of the second data, and the even sampling circuit performs sampling based on the second clock even signal ECK.

As shown in FIG. 14, in the odd mode, the second clock odd signal OCK is valid, and the second clock even signal ECK is masked. Correspondingly, the second clock odd delayed signal OCKD is valid, and the second clock even delayed signal ECKD is also masked. Therefore, odd selection circuits of the first selection circuit 500_1 and the second selection circuit 500_2 are active, receiving the first piece of the second data B0 and B1, performing sampling based on the second clock odd signal OCK, and outputting the third data D0 as B0B1. Odd selection circuits of the third selection circuit 500_3 and the fourth selection circuit 500_4 are active, receiving the first piece of the second data B2 and B3, performing sampling based on the second clock odd delayed signal OCKD, and outputting the third data D1 as B2B3. Because the second clock odd delayed signal OCKD is delayed by half a clock cycle compared with the second clock odd signal OCK, the generated third data D1 is also delayed by half a clock cycle compared with the third data D0, that is, D0D1 = B0B1B2B3. As mentioned above, the levels of the M serial data bits in each piece of the second data are the same. Therefore, in different clock cycles of the second clock odd signal OCK, as long as the received second data is the same, the two pieces of the third data correspondingly output by the N selection circuits are also the same. For example, if the second data B0B1B2B3 is 0001 and the corresponding valid pulse width is equal to four clock cycles of the second clock odd signal OCK, the output third data D0D1 is also 0001 in the four clock cycles of the second clock odd signal OCK.

As shown in FIG. 15, in the even mode, the second clock even signal ECK is valid, and the second clock odd signal OCK is masked. Correspondingly, the second clock even delayed signal ECKD is valid, and the second clock odd delay signal OCKD is masked. Therefore, even selection circuits of the first selection circuit 500_1 and the second selection circuit 500_2 are active, one end of the selector receives the first piece of the second data B0 and B1, another end of the selector receives the second piece of the second data B2 and B3, and the control end of the selector receives the first selection signal SEL. The first selection signal may be generated based on the register code OP[6:4] of the mode register MR 42. Specifically, an input end of a NOR gate is used to receive the register code OP[6:4] of the mode register MR 42, and an output end of the NOR gate outputs the first selection signal SEL. As can be learned from Table 1, when the memory is in the second mode, that is, the duty cycle training assist mode, at least one bit of the register code OP[6:4] of the mode register MR 42 is 1, and the first selection signal SEL is 0. When the memory is in the first mode, the register code OP[6:4] of the mode register MR 42 is 000, and the first selection signal SEL is 1. Correspondingly, when the first selection signal is at the first level (0), the selector outputs the first piece of the second data B0 and B1. When the first selection signal is at the second level (1), the selector outputs the second piece of the second data B2 and B3, and the even sampling circuit performs sampling based on the second clock even delayed signal ECKD, and outputs the third data D0 as B0B1 or B2B3. Even selection circuits of the third selection circuit 500_3 and the fourth selection circuit 500_4 are active, one end of the selector receives the first piece of the second data B2 and B3, another end of the selector receives the second piece of the second data B0 and B1, and the control end of the selector receives the first selection signal SEL. The first selection signal may be generated based on the register code OP[6:4] of the mode register MR 42. Specifically, an input end of a NOR gate is used to receive the register code OP[6:4] of the mode register MR 42, and an output end of the NOR gate outputs the first selection signal SEL. As can be learned from Table 1, when the memory is in the second mode, that is, the duty cycle training assist mode, at least one bit of the register code OP[6:4] of the mode register MR 42 is 1, and the first selection signal SEL is 0. When the memory is in the first mode, the register code OP[6:4] of the mode register MR 42 is 000, and the first selection signal SEL is 1. Correspondingly, when the first selection signal is at the first level (0), the selector outputs the first piece of the second data B2 and B3. When the first selection signal is at the second level (1), the selector outputs the second piece of the second data B0 and B1, and the even sampling circuit performs sampling based on the second clock even signal ECK, and outputs the third data D1 as B2B3 or B0B1. Because the second clock even delayed signal ECKD is delayed by half a clock cycle compared with the second clock even signal ECK, the generated third data D0 is also delayed by half a clock cycle compared with the third data D1, that is, D1D0 = B2B3B0B1 (corresponding to the first selection signal SEL = 0, that is, the duty cycle training assist mode) or B0B1B2B3 (corresponding to the first selection signal SEL = 1, that is, the normal read mode). Therefore, in the odd/even mode, the data output by the memory in the normal read mode is the same, but the data output in the duty cycle training assist mode is different, and the output data is respectively the first bit corresponding to the odd mode and the third bit corresponding to the even mode. In this way, the controller can determine, based on the received data, whether the current clock of the memory is the ICLK or the IBCLK, and then adjust the duty cycle of the clock signal.

It should be noted that, as shown in FIG. 15, in the even mode, if the second data B0B1B2B3 is 0001 and the corresponding valid pulse width is equal to three clock cycles of the second clock even signal ECK, the output third data D1D0 is switched to 0011 in a fourth clock cycle of the second clock even signal ECK.

In an embodiment of the present disclosure, the memory further includes an output module, connected to the N selection circuits and configured to receive the two pieces of the third data and output fourth data to an input/output interface, where the fourth data includes N*M serial data bits. As shown in FIG. 14 and FIG. 15, the two pieces of the third data D0 and D1 are in a parallel output relationship. Therefore, the memory further needs to be provided with an output module to sample the two pieces of parallel third data and output the fourth data to the input/output interface. Herein, the fourth data includes the N*M serial data bits, which may be data read out from a storage cell or the preset data pattern generated based on the register code OP[6:4] of the mode register MR 42. Each data bit can correspond to one clock cycle of the system clock signal. In this way, the controller can determine the ICLK or the IBCLK based on whether a first BL received is the first bit or the third bit of the preset data pattern, and then can adjust the duty cycle of the clock signal.

An embodiment of the present disclosure further provides a memory device, including the memory provided by the foregoing embodiment. The memory device is described in detail below. It should be noted that the description of the foregoing embodiment is also applicable to the embodiment of the memory device. To avoid repetition, content mentioned in the foregoing embodiment is not described in detail again below.

The memory device includes: the memory provided in the foregoing embodiment; and a controller, where the controller is coupled to the memory and configured to enable the memory device to: send a command to the memory through the controller, where the command includes a normal read command or a duty cycle training assist mode command, and the memory reads out data based on the received command; and if the command is the duty cycle training assist mode command, compare the data received by the memory device through the controller with preset data to determine and adjust a duty cycle of a system clock signal.

Refer to FIG. 16, which shows a schematic diagram of a composition structure of a memory device according to another embodiment of the present disclosure. As shown in FIG. 16, the memory device includes a memory 10 and a controller 20. The controller 20 is coupled to the memory 10 by using a plurality of buses.

The controller 20 sends a command to the memory 10 through a command/address bus, where the command includes a normal read command or a duty cycle training assist mode command DCA training command. The memory 10 reads out data to a data bus based on the received command. The data herein may be data stored in a storage cell, or data generated by the memory based on the duty cycle training assist mode command. If the data is the duty cycle training assist mode command DCA training command, the memory device may compare the data received by the controller 20 with preset data; if a first bit of the received data is a first bit of the preset data, determine that a clock is an ICLK; if the first bit of the received data is a third bit of the preset data, determine that the clock is an IBCLK; and then adjust a duty cycle of a system clock signal accordingly to complete duty cycle training.

A person of ordinary skill in the art may understand that the foregoing embodiments are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A memory, comprising:
a plurality of storage cells arranged in an array, configured such that when a storage cell is selected, data stored in the storage cell is read out from a bit line to a first data bus Abus; and
a set circuit 100, connected to the first data bus Abus to receive a set signal, and configured to enable the first data bus Abus based on the set signal and output a first data bit when the memory is in a first mode, or disable the first data bus Abus based on the set signal and output a preset data bit when the memory is in a second mode, wherein
the first mode is a normal read mode, and the second mode is a duty cycle training assist mode.

2. The memory according to claim 1, wherein the set circuit comprises a setter, the set signal comprises a first set signal BUSL and a second set signal BUSH, an input end of the setter is connected to the first data bus Abus, a first set end receives the first set signal BUSL, and a second set end receives the second set signal BUSH, wherein
in the first mode, levels of the first set signal BUSL and the second set signal BUSH are different, or in the second mode, levels of the first set signal BUSL and the second set signal BUSH are the same.

3. The memory according to claim 1, further comprising a decoding circuit 200, configured to receive a register code of a mode register and perform decoding to generate the set signal.

4. The memory according to claim 3, further comprising a latch circuit 300, connected to the decoding circuit 200 to receive a mode register write signal MRW, and configured such that when the mode register write signal MRW is valid, the latch circuit 300 is controlled to output the set signal, or that when the mode register write signal MRW is invalid, the latch circuit 300 is controlled to latch the set signal.

5. The memory according to claim 1, further comprising N parallel-to-serial conversion circuits, each of which is correspondingly connected to M set circuits 100 and configured to receive data bits output by the M set circuits 100 and sample the data bits based on a first clock signal, and perform logic processing to generate second data, each piece of the second data comprising M serial data bits, wherein N and M are even integers.

6. The memory according to claim 5, wherein a clock cycle of the first clock signal is M times a clock cycle of a system clock signal, and in each of the parallel-to-serial conversion circuits, valid pulse periods of first clock signals received by the M set circuits 100 do not overlap each other.

7. The memory according to claim 6, wherein when the memory is in the second mode, levels of the M serial data bits in each piece of the second data are the same, and N is equal to the number of bits in a preset data pattern.

8. The memory according to claim 5, wherein the parallel-to-serial conversion circuit further receives a first write signal FIFO_IN, and is configured such that when the first write signal FIFO_IN is valid, the parallel-to-serial conversion circuit triggers the generation of the second data.

9. The memory according to claim 5, further comprising N selection circuits, each of which is connected to two of the parallel-to-serial conversion circuits to receive the corresponding second data and is configured as follows:
when the memory is in the first mode, the second data output by N/2 of the selection circuits in an odd mode is the same as the second data output by other N/2 of the selection circuits in an even mode; and
when the memory is in the second mode, the second data output by the N/2 of the selection circuits in the odd mode is different from the second data output by the other N/2 of the selection circuits in the even mode, wherein
two parallel-to-serial conversion circuits connected to each of the N/2 selection circuits are the same as two parallel-to-serial conversion circuits connected to a corresponding one of the other N/2 selection circuits.

10. The memory according to claim 9, wherein the N selection circuits are configured as follows:
when the memory is in the first mode, the second data output by first N/2 of the selection circuits in the odd mode is the same as the second data output by last N/2 of the selection circuits in the even mode; and
when the memory is in the second mode, the second data output by the first N/2 of the selection circuits in the odd mode is different from the second data output by the last N/2 of the selection circuits in the even mode, wherein
two parallel-to-serial conversion circuits connected to each of the first N/2 selection circuits are the same as two parallel-to-serial conversion circuits connected to a corresponding one of the last N/2 selection circuits.

11. The memory according to claim 9, wherein the N selection circuits further receive second clock signals, perform sampling, and output two pieces of third data, each piece of the third data comprising N/2 pieces of parallel second data, wherein
in the odd mode, the second clock signals received by the N/2 of the selection circuits are advanced by half a clock cycle compared with the second clock signals received by the other N/2 of the selection circuits; and
in the even mode, the second clock signals received by the N/2 of the selection circuits are delayed by half a clock cycle compared with the second clock signals received by the other N/2 of the selection circuits.

12. The memory according to claim 10, wherein the second clock signals comprise a second clock odd signal OCK and a second clock even signal ECK, clock cycles of the second clock odd signal OCK and the second clock even signal ECK are the same, and only one of the second clock odd signal OCK and the second clock even signal ECK is valid at a same moment;
the odd mode corresponds to the second clock odd signal OCK being valid, and the even mode corresponds to the second clock even signal ECK being valid;
in the odd mode, the N/2 of the selection circuits perform sampling based on the second clock odd signal OCK, and the other N/2 of the selection circuits perform sampling based on a second clock odd delayed signal OCKD; and
in the even mode, the N/2 of the selection circuits perform sampling based on a second clock even delayed signal ECKD, and the other N/2 of the selection circuits perform sampling based on the second clock even signal ECK, wherein
the second clock odd delayed signal OCKD is delayed by half a clock cycle compared with the second clock odd signal OCK, and the second clock even delayed signal ECKD is delayed by half a clock cycle compared with the second clock even signal ECK.

13. The memory according to claim 12, wherein each of the selection circuits comprises an odd selection circuit and an even selection circuit, the odd selection circuit comprises an odd sampling circuit connected to one of the parallel-to-serial conversion circuits to receive a first piece of the second data, the even selection circuit comprises a selector MUX and an even sampling circuit connected to two of the parallel-to-serial conversion circuits, one end of the selector MUX receives the first piece of the second data, another end of the selector MUX receives a second piece of the second data, a control end of the selector receives a first selection signal SEL, and the selection circuits are configured as follows:
in the odd mode, the odd selection circuit receives the first piece of the second data and performs sampling based on the second clock odd signal OCK; and
in the even mode, when the first selection signal SEL is at a first level, the selector MUX outputs the first piece of the second data, or when the first selection signal SEL is at a second level, the selector MUX outputs the second piece of the second data, and the even sampling circuit performs sampling based on the second clock even delayed signal ECKD; or
in the odd mode, the odd selection circuit receives the first piece of the second data and performs sampling based on the second clock odd delayed signal OCKD; and
in the even mode, when the first selection signal SEL is at a first level, the selector MUX outputs the first piece of the second data, or when the first selection signal SEL is at a second level, the selector MUX outputs the second piece of the second data, and the even sampling circuit performs sampling based on the second clock even signal ECK.

14. The memory according to claim 11, further comprising an output module, connected to the N selection circuits and configured to receive the two pieces of the third data and output fourth data to an input/output interface, wherein the fourth data comprises N*M serial data bits.

15. A memory device, comprising the memory 10 according to any one of claims 1 to 14; and a controller 20, wherein the controller 20 is coupled to the memory 10 and configured to enable the memory device to:
send a command to the memory 10 through the controller 20, wherein the command comprises a normal read command or a duty cycle training assist mode command, and the memory 10 reads out data based on the received command; and if the command is the duty cycle training assist mode command, compare the data received by the memory device through the controller 20 with preset data to determine and adjust a duty cycle of a system clock signal.
